# EUROPEAN PATENT APPLICATION

(11) **EP 4 417 575 A1**
(43) Date of publication of application: **21.08.2024**
(21) Application number: 21960738.9
(22) Date of filing: 12.11.2021
(51) Int. Cl.: C01B 32/194, B32B 38/18, B32B 38/00, B32B 37/00, B32B 43/00

(54) **GRAPHENE TRANSFER SYSTEM USING HEAT TREATMENT MODULE AND GRAPHENE TRANSFER METHOD USING SAME**

(30) Priority: 14.10.2021 KR 20210136743
(71) Applicant: Alpha Graphene Inc., Pohang-si, Gyeongsangbuk-do 37673 (KR)
(72) Inventor: LEE, Sang Kyung, Pohang-si, Gyeongsangbuk-do 37539 (KR)
(74) Representative: Gulde & Partner
(86) International application number: PCT/KR2021/016499
(87) International publication number: WO 2023/063473

(57) **Abstract**

Disclosed are a graphene transfer system capable of improving quality and mass productivity and a graphene transfer method using same. By providing a substrate supply unit capable of supplying a substrate loading unit and a graphene transport unit in a vacuum state or a standby state, the process time can be shortened and product quality can be prevented from degrading by external contamination. In addition, since before a graphene transfer process is performed, the moisture remaining on the substrate loading unit can be removed by using a heat treatment module, and the substrate loading unit can be rapidly cooled by using the heat treatment module heated in the heat treatment process, the process time can be shortened. Therefore, graphene transfer quality can be improved, and the mass productivity according to shortening of the process time can be improved.

## Description

### Technical Field

The present disclosure relates to a graphene transfer system using a heat treatment module and a graphene transfer method using the same, and more specifically, to a graphene transfer system using a heat treatment module capable of improving quality and productivity, and a graphene transfer method using the same.

### Background Art

Graphene refers to a single layer of carbon atoms arranged in a honeycomb lattice shape in a two-dimensional space, with a thickness of 0.2 nm, and exhibits high stability both physically and chemically. Specifically, graphene has high charge mobility, excellent transparency, and outstanding flexibility and strength, thereby making it a highly promising material for next-generation electronic and optoelectronic devices. Moreover, the excellent flexural properties and high sensitivity to light of graphene can enhance the efficiency of elements, such as solar cells and LEDs, and can also be applied to elements such as touchscreens and photodetectors, thereby gradually expanding the range of applications.

Graphene can be typically produced through a method of synthesizing it on a metal layer using chemical vapor deposition (CVD) . It is because graphene produced by the CVD method exhibits superior properties and allows for mass production. However, when graphene is produced using the CVD method, since graphene is synthesized on a silicon wafer substrate or a metal substrate having a metal catalyst layer formed thereon, it is necessary to transfer the graphene synthesized on the metal layer to a desired substrate in order to apply the graphene to elements.

In general, for the graphene transfer process, a method of transferring graphene formed on the metal layer to a desired substrate using an adhesive support layer, such as thermal releasing tape, polydimethylsiloxane (PDMS), or polymethyl methacrylate (PMMA).

However, when graphene is transferred through the transfer method, foreign substances are formed between the graphene and the substrate due to moisture generated during the wet etching process or oxygen and impurities existing in the air during the graphene transfer, it results in poor graphene transfer quality. Additionally, due to weak adhesion between graphene and the substrate, the quality of graphene may be easily damaged when manufacturing elements using the transferred graphene.

To overcome the above problems, a method of transferring graphene onto a substrate such as a wafer within a vacuum apparatus has been disclosed. That is, by performing the transfer process of graphene within the vacuum apparatus, factors causing doping between the graphene and the transfer substrate can be removed, thereby securing the inherent characteristics of graphene.

FIG. 1 is a diagram illustrating a conventional graphene transfer device.

FIG. 2 is an image illustrating graphene transferred using the conventional graphene transfer device.

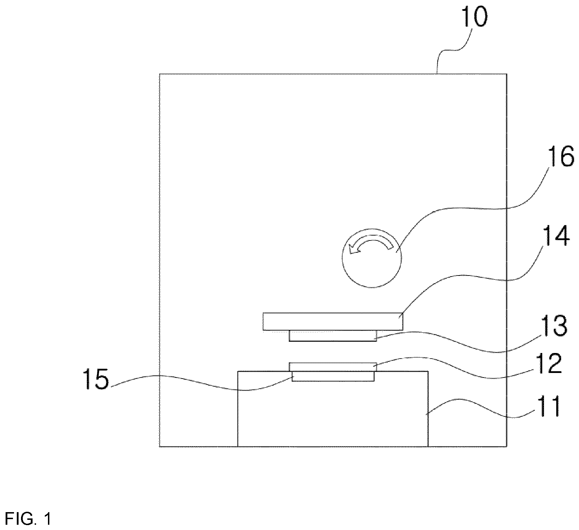

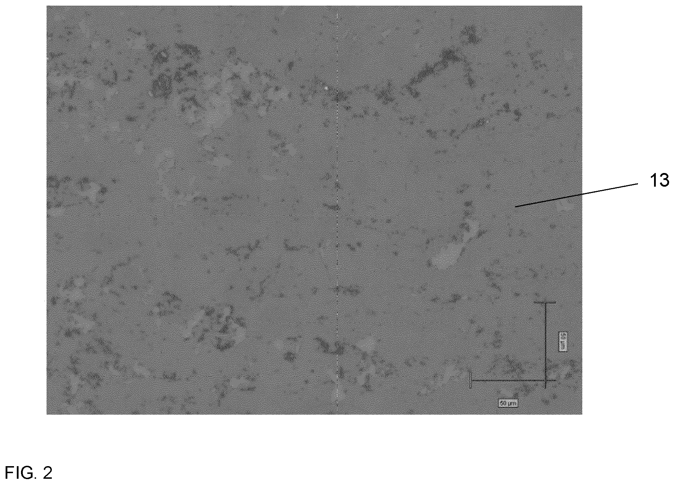

Referring to FIGS. 1 and 2, the conventional graphene transfer device includes a transfer substrate 12 placed on a support base 11 arranged within a vacuum chamber 10, and a carrier substrate 14 placed on the transfer substrate 12 so that graphene 13 is positioned adjacent to the transfer substrate 12. In the state in which graphene 13 is positioned adjacent to the transfer substrate 12, a roller 16 is used to apply pressure to the carrier substrate 14, and heat is applied to the transfer substrate 12 and graphene using a heat supply unit 15 disposed on the support base 11 to transfer the graphene 13 onto the transfer substrate 12.

However, in the case of the conventional graphene transfer device, the vacuum chamber 10 must be opened every time to introduce and discharge the transfer substrate 12 and carrier substrate 14 into or from the vacuum chamber 10 for the graphene transfer process. That is, each time the transfer substrate 12 and the carrier substrate 14 are introduced or removed, a process of opening or vacuuming the vacuum chamber 10 is required. For example, to create a vacuum environment of 1 mTorr or less inside the vacuum chamber 10, it takes at least 30 minutes, and the process of opening the vacuum chamber 10 also takes over 10 minutes. As the size of the vacuum chamber increases, more time is required, so the overall process time increases. Moreover, the product quality lowers due to pollution inside the vacuum chamber 10 since the vacuum chamber 10 must be opened and closed each time. Therefore, it inevitably leads to lower productivity in producing graphene transfer substrates.

Furthermore, the conventional graphene transfer device must simultaneously perform the graphene transfer process and the process of separating the carrier substrate 14 while applying pressure and heat by a roller 16 inside one vacuum chamber 10. Accordingly, as illustrated in FIG. 2, damage and contamination of graphene 13 occur together, and a significant amount of time is required to cool the heat applied for the heat treatment process, resulting in reduced productivity when performing multiple graphene processes.

### Disclosure

### Technical Problem

Accordingly, the present invention has been made in view of the above-mentioned problems occurring in the related art, and it is an object of the present invention to provide a graphene transfer system using a heat treatment module capable of improving product quality and productivity using a plurality of vacuum chambers formed for a graphene transfer process and a heat treatment module, and a graphene transfer method using the same.

### Technical Solution

To accomplish the above-mentioned objects, according to the present invention, there is provided a graphene transfer system using a heat treatment module, including: a substrate supply unit supplying a substrate loading unit and a graphene transfer unit in a vacuum condition and performing a first heat treatment process; a substrate processing unit receiving the graphene transfer unit and the substrate loading unit and performing a graphene transfer process through a second heat treatment process; and a substrate discharge unit for discharging the substrate loading unit, after completion of the graphene transfer process in the substrate processing unit, wherein the graphene transfer unit includes a carrier substrate to which graphene is adhered, and wherein the substrate loading unit includes a heat treatment module for performing the first heat treatment process and the second heat treatment process.

The substrate loading unit includes: a transfer substrate on which the graphene is transferred; and a jig on which the transfer substrate is place.

The heat treatment module is arranged under the jig.

The jig includes a seating groove for inserting and placing the transfer substrate into the jig.

The upper surface of the jig is in the same plane as the upper surface of the transfer substrate.

The heat treatment module includes a Peltier device.

The substrate supply unit includes: a first load lock chamber supplying the substrate loading unit to the substrate processing unit in the vacuum condition; and a second load lock chamber supplying the graphene transfer unit to the substrate processing unit in the vacuum condition.

The first load lock chamber includes a first power supply unit for supplying power to the heat treatment module.

The substrate processing unit includes: a first transfer chamber receiving the substrate loading unit and the graphene transfer unit from the substrate supply unit, and performing a first roll-to-plate process in the vacuum condition; and a second transfer chamber receiving the substrate loading unit and the graphene transfer unit from the first transfer chamber, and performing a second heat treatment process and a second roll-to-plate process.

The first transfer chamber includes: a first support base, which is placed under the first transfer chamber, and on which the substrate loading unit is placed; and a first roller which is placed on the upper part of the first transfer chamber, and applies pressure to the graphene transfer unit to bond the graphene to the substrate loading unit.

The first support base includes a second power supply unit for supplying power to the heat treatment module, and the heat treatment module cools the substrate loading unit by the second power supply unit.

The second transfer chamber includes: a second support base which is placed under the second transfer chamber, and on which the substrate loading unit is placed; and a second roller which is placed on the upper part of the second transfer chamber to remove the carrier substrate from the graphene transfer unit.

The second support base includes a third power supply unit for supplying power to the heat treatment module, and the heat treatment module supplies heat to the substrate loading unit by the third power supply unit.

The second roller includes a barb-shaped protrusion formed on the outer surface thereof.

In another aspect of the present invention, there is provided is a graphene transfer method of a graphene transfer system using a heat treatment module, including the steps of: placing a transfer substrate on a jig and a graphene transfer unit including a carrier substrate to which graphene is adhered, and preparing a substrate loading unit having a heat treatment module arranged on the bottom of the jig; loading the substrate loading unit and the graphene transfer unit onto a substrate supply unit in a vacuum or atmospheric condition, and performing a first heat treatment process using the heat treatment module; transferring the substrate loading unit and the graphene transfer unit to a substrate processing unit in the vacuum condition; performing a second heat treatment process in the substrate processing unit using the heat treatment module, and performing a graphene transfer process using the second heat treatment process; and transferring the substrate loading unit with the transferred graphene to a substrate discharge unit.

The step of loading the substrate loading unit and the graphene transfer unit onto the substrate supply unit includes the steps of: loading the substrate loading unit into a first load lock chamber; and loading the graphene transfer unit into a second load lock chamber.

The graphene transfer method further includes the step of: after loading the substrate loading unit into the first load lock chamber, supplying power to the heat treatment module in the first load lock chamber to perform the first heat treatment process.

The step of performing the graphene transfer process includes the steps of: transferring the substrate loading unit and the graphene transfer unit to a first transfer chamber; and transferring the substrate loading unit and the graphene transfer unit from the first transfer chamber to a second transfer chamber.

The step of performing the graphene transfer process includes the steps of: performing a first roll-to-plate process in the first transfer chamber; and performing a second heat treatment process and a second roll-to-plate process in the second transfer chamber.

The step of performing the first roll-to-plate process includes the steps of: applying power to the heat treatment module to cool the substrate loading unit; and positioning the graphene transfer unit close to the substrate loading unit and applying pressure to the upper portion of the positioned graphene transfer unit using a first roller.

The step of performing the second heat treatment process and the second roll-to-plate process includes the steps of: applying power to the heat treatment module to supply heat to the substrate loading unit and the graphene transfer unit; and removing the carrier substrate of the graphene transfer unit using a second roller in the state in which the heat is supplied.

### Advantageous Effect

According to the present invention, by including the substrate supply unit capable of supplying the substrate loading unit and the graphene transfer unit in a vacuum or atmospheric condition, the process time can be shortened, and deterioration of product quality due to external contamination can be prevented. Therefore, the present invention can significantly improve the productivity for the graphene transfer process.

Furthermore, by using the heat treatment module, the present invention can remove moisture remaining in the substrate loading unit before the graphene transfer process is performed and rapidly cool the substrate loading unit heated by the heat treatment process, thereby shortening the process time. Therefore, the present invention can enhance the quality of graphene transfer and improve productivity due to the reduction in process time.

In addition, by separating the first roll-to-plate process for bonding graphene to the transfer substrate from the second roll-to-plate process for heat treatment and separation of the carrier substrate, the present invention can prevent damage and contamination of graphene due to pressure and heat applied to the carrier substrate.

The effects of the present invention are not limited to the above-mentioned effects, and other effects, which are not specifically mentioned herein, will be clearly understood by those skilled in the art from the following description.

### Description of Drawings

FIG. 1 is a diagram illustrating a conventional graphene transfer device.
FIG. 2 is an image illustrating graphene transferred using the conventional graphene transfer device.

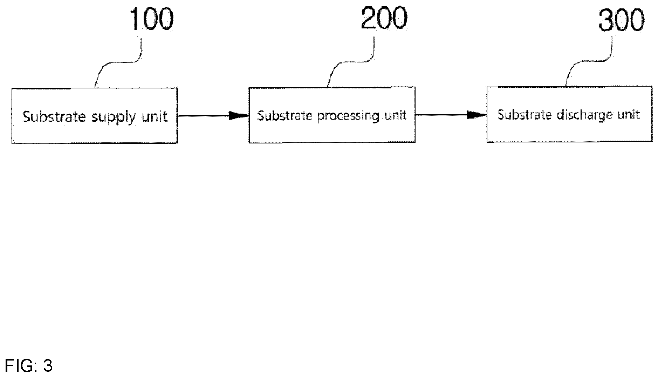

FIG. 3 is a schematic block diagram illustrating a graphene transfer system according to the present invention.

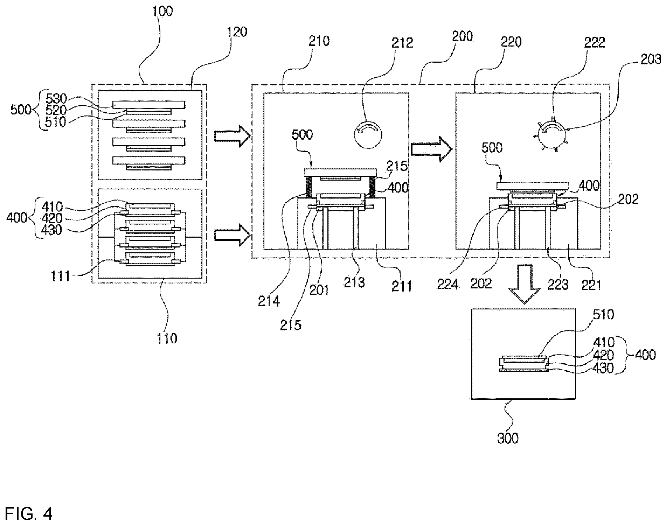

FIG. 4 is a diagram illustrating the graphene transfer system of the present invention.

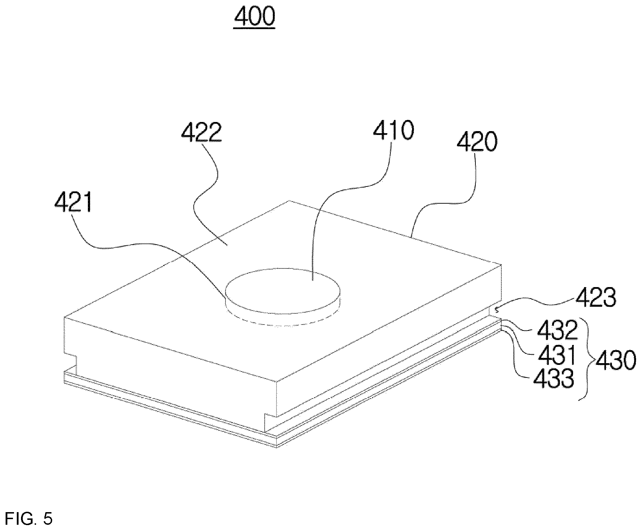

FIG. 5 is a diagram illustrating a substrate loading unit of the present invention.

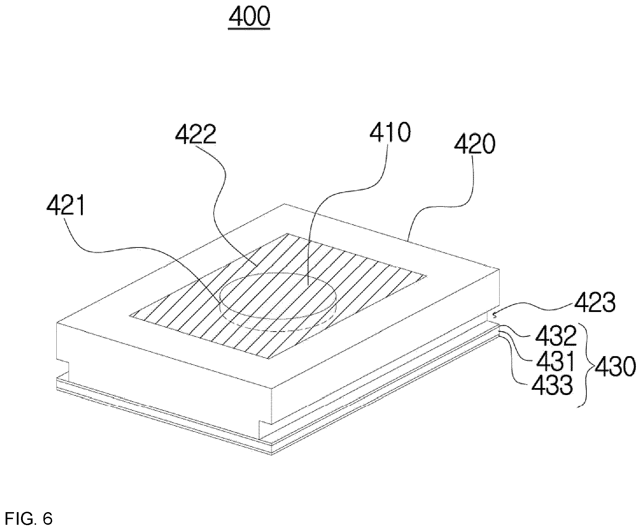

FIG. 6 is a diagram illustrating a graphene transfer area using the graphene transfer device of the present invention.

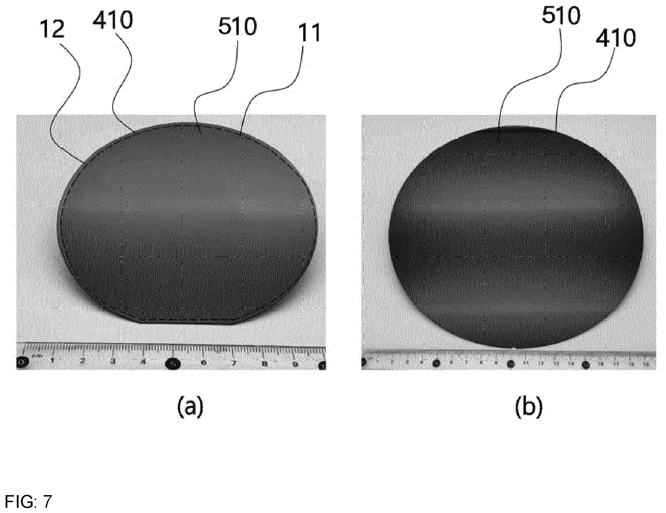

FIG. 7 is a diagram comparing the graphene transfer area using the graphene transfer device of the present invention with the conventional graphene transfer area.

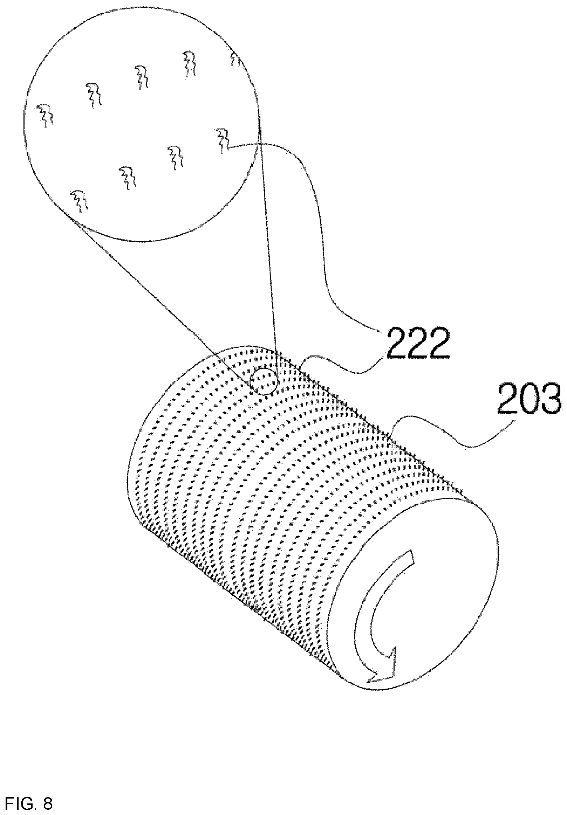

FIG. 8 is a diagram illustrating the second roller of the present invention.

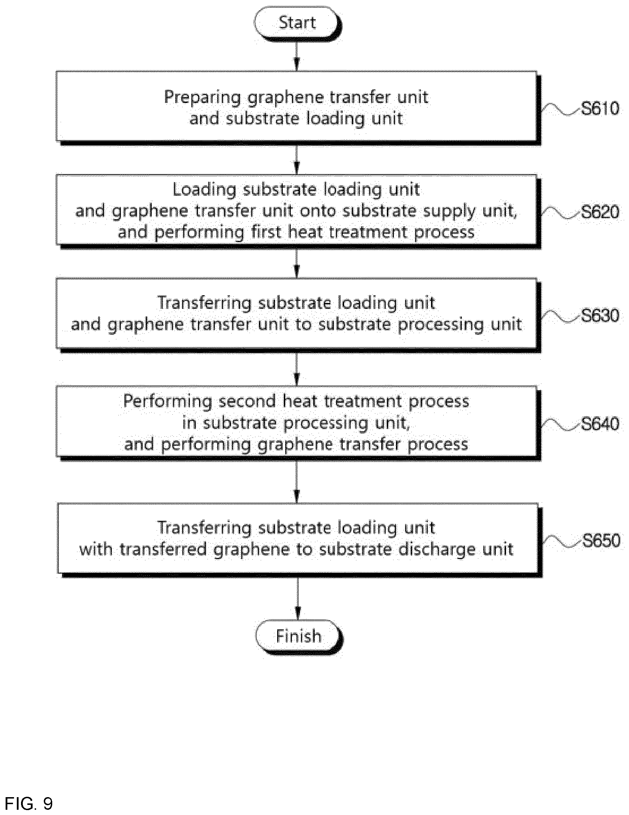

FIG. 9 is a flowchart illustrating the graphene transfer method using the graphene transfer system of the present invention.

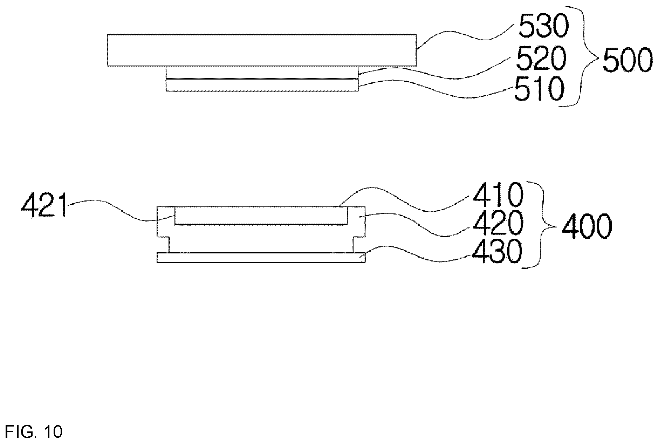

FIGS. 10 to 16 are diagrams sequentially illustrating a graphene transfer method using the graphene transfer system of the present invention.

### Mode for Invention

The present invention may undergo various modifications and have several embodiments, so specific embodiments are exemplified in the drawings and described in detail in the detailed description. However, it is not intended to limit the present invention to specific embodiments, and it should be understood to include all modifications, equivalents, or substitutes falling within the scope of the concept and technical scope of the present invention. In describing the present invention, detailed description of relevant prior art that may obscure the essence of the present invention are omitted.

Hereinafter, exemplary embodiments according to the present invention will be described in detail with reference to the accompanying drawings. The same or equivalent reference numbers in the drawings refer to the same or equivalent components of the present invention, and redundant descriptions thereof will be omitted.

FIG. 3 is a schematic block diagram illustrating a graphene transfer system according to the present invention.

FIG. 4 is a diagram illustrating the graphene transfer system of the present invention.

Referring to FIGS. 3 and 4, the graphene transfer system according to the present invention includes a substrate supply unit 100, a substrate processing unit 200, and a substrate discharge unit 300.

The substrate supply unit 100 supplies a substrate to the substrate processing unit 200 in a vacuum or atmospheric condition. In this instance, the substrate transferred to the substrate processing unit 200 may include a substrate loading unit 400 containing a transfer substrate 410 or a graphene transfer unit 500 containing the graphene 510. For example, the substrate supply unit 100 may have the atmospheric condition when the graphene transfer unit 500 or the substrate loading unit 400 is loaded from the outside to the substrate supply unit 100, and may have the vacuum condition when the graphene transfer unit 500 or the substrate loading unit 400 is moved from the substrate supply unit 100 to the substrate processing unit 200.

The substrate supply unit 100 may include a first load lock chamber 110 and a second load lock chamber 120.

A plurality of substrate loading units 400 may be supplied and arranged in the first load lock chamber 110 from the outside. Additionally, the first load lock chamber 110 may communicate with the substrate processing unit 200. For example, the plurality of substrate loading units 400 may be transferred to the substrate processing unit 200 in predetermined units.

The first load lock chamber 110 may have the vacuum or atmospheric condition. For example, when the first load lock chamber 110 is in the atmospheric condition, the substrate loading units 400 may be supplied from the outside to the first load lock chamber 110. Additionally, when the first load lock chamber 110 is in the vacuum condition, the substrate loading units 400 may be transferred from the first load lock chamber 110 to the substrate processing unit 200.

FIG. 5 is a diagram illustrating the substrate loading unit of the present invention.

Referring to FIG. 5, the substrate loading unit 400 according to the present invention may include a transfer substrate 410 on which the graphene 510 is transferred, a jig 420 on which the transfer substrate 410 is placed, and a heat treatment module 430 for heating or cooling the substrate loading unit. That is, the transfer substrate 410 may be placed on the jig 420, and the substrate loading unit 400 equipped with the heat treatment module 430 may be supplied to the first load lock chamber 110.

The transfer substrate 410 can be applied to any substrate for transfer of graphene 510. For example, the transfer substrate 410 may be one of silicon wafers, glass, ion exchange films, polyimide (PI), polyethylene naphthalate (PEN), polyethylene terephthalate (PET), and polycarbonate (PC).

The jig 420 may have a seating groove 421 formed on the upper surface thereof to insert and fix the transfer substrate 410. It is desirable for the seating groove 421 to have the same shape and size as the transfer substrate 410, so the transfer substrate 410 can be fixed onto the jig 420.

In this case, it is preferable for the seating groove 421 to be formed such that the upper surface of the transfer substrate 410 and the upper surface of the jig 420 become the same plane when the transfer substrate 410 is placed on the seating groove 421. That is, the depth of the seating grooves 421 may be the same size as the thickness of the transfer substrate 410. For example, a circular silicon wafer can be inserted into the center of a rectangular jig 420 to be fixed.

Furthermore, the upper surface of the jig 420 may have a peripheral area 422 excluding the area where the transfer substrate 410 is placed. For example, if a circular transfer substrate 410 is mounted in the center of a rectangular jig 420, the upper surface of the jig 420 may have a peripheral area 422 excluding the area of the circular transfer substrate 410.

FIG. 6 is a diagram illustrating the graphene transfer area using the graphene transfer system of the present invention.

Referring to FIG. 6, the transfer area of the graphene 510 using the graphene transfer system according to the present invention may include not only the upper area of the transfer substrate 410 placed on the jig 420 but also the peripheral area 422 of the jig 420, since the upper surface of the jig 420 is in the same plane as the upper surface of the transfer substrate 410 and the jig 420 is formed to have the peripheral area 422 around the transfer substrate 410.

That is, the peripheral area 422 on the upper surface of the jig 420 can function as an expanded area of the transfer substrate 410. For example, the rectangular graphene 510 transferred onto the circular transfer substrate 410 can be transferred to a wider transfer aera than the circular transfer substrate 410. In other words, the graphene 510 can be transferred onto the substrate loading unit 400 in a manner that covers the entire upper surface of the circular transfer substrate 410 and extends to the peripheral area 422 of the jig 420. Therefore, even if the rectangular graphene 510 is transferred onto the circular transfer substrate 410, the graphene 510 can be transferred onto the transfer substrate 410 to cover the entire upper surface of the transfer substrate 410.

Furthermore, because the graphene 510 can be transferred to extend beyond the transfer substrate 410 to the peripheral area 422 of the jig 420, precise alignment is not required to transfer the graphene 510 onto the transfer substrate 410.

FIG. 7 is a diagram comparing the graphene transfer area using the graphene transfer device of the present invention with the conventional graphene transfer area.

FIG. 7(a) represents the conventional graphene transfer area, while FIG. 7(b) represents the graphene transfer area using the graphene transfer device of the present invention.

Referring to FIGS. 7(a) and (b), in the conventional graphene transfer area as illustrated in FIG. 7(a), even when the graphene 510 is transferred to the maximum area 11 through precise alignment, there exists a graphene non-transfer area 12 at the outermost edge of the transfer substrate 410. Additionally, there is a problem of deteriorating product production and quality degradation because the transfer position for transferring to the maximum area 11 must be determined by a worker's determination.

However, in relation to the graphene transfer area according to the present invention using the jig 420, as illustrated in FIG. 7(b), it can be confirmed that the graphene 510 is transferred over the entire upper surface area of the transfer substrate 410. That is, because the graphene 510 transfer area using the jig 420 can extend beyond the area of the transfer substrate 410 to the peripheral area 422 of the jig 420, precise alignment of the graphene transfer unit 500 is not required as in the conventional method. Additionally, without precise alignment of the graphene transfer unit 500, the graphene 510 can be transferred onto the entire upper surface of the transfer substrate 410, thereby improving product production and quality.

The heat treatment module 430 may be arranged at the lower portion of the substrate loading unit. In other words, the heat treatment module 430 may be attached and arranged on the lower surface of the jig 420. Additionally, power grooves 423 for supplying power to the heat treatment module 430 may be formed on both lower sides of the substrate loading unit 400.

The heat treatment module 430 may be, for example, a Peltier device. The Peltier device may include a P-N semiconductor component 431, and a first heat transfer surface 432 provided on one side of the P-N semiconductor component 431, and a second heat transfer surface 433 provided on the other side of the P-N semiconductor component 431, as disclosed. In this case, the P-N semiconductor components 431 arranged between the first heat transfer surface 432 and the second heat transfer surface 433 may have a form in which the plurality of P-N semiconductor components 431 are connected in series.

For example, the first heat transfer surface 432 may be attached to the lower surface of the jig 420, and the second heat transfer surface 433 may be positioned on the surface facing the lower surface of the jig 420. Depending on the direction of the applied current, the first heat transfer surface 432 of the Peltier device may be heated, while the second heat transfer surface 433 may be cooled, or vice versa. Thus, depending on the direction of the applied current, the substrate loading unit 400 attached to the first heat transfer surface 432 of the Peltier device may be heated or cooled.

By utilizing the heat treatment module 430 having the characteristics of the Peltier device, it is possible to shorten the cooling time for cooling the heated substrate loading unit 400 after heating the substrate loading unit 400 for heat treatment. For example, to remove moisture of the transfer substrate 400, the substrate loading unit 400 is heated by using the heat treatment module 430, and then, the heated substrate loading unit 400 can be rapidly cooled using the characteristics of the Peltier device before the pressurization process using rollers is performed. Thus, the present invention can improve the quality of the product by removing residual moisture from the transfer substrate 410 by using the heat treatment module 430 and significantly enhance the mass production efficiency for graphene transfer by rapidly cooling the substrate loading unit 400 before the process using rollers is performed.

The first load lock chamber 110 may perform a first heat treatment process using the heat treatment module 430 of the above described substrate loading unit 400. For the first heat treatment process, a first power supply unit 111 for supplying power to each heat treatment module 430 may be formed inside the first load lock chamber 110. The first power supply unit 111 may be inserted into the power groove 423 of the substrate loading unit 400 to electrically connect with the heat treatment module 430.

For example, the transfer substrate 410, which is placed on the substrate loading unit 400, such as a wafer substrate, undergoes a cleaning process before being supplied to the first load lock chamber 110. However, even after the cleaning process, moisture remaining during the cleaning process may not be completely removed and may still remain on the transfer substrate 410. If the transfer process of the graphene 510 is performed on the transfer substrate 410 while moisture remains on the transfer substrate 410, the graphene 510 may be contaminated, leading to defects in the product.

Therefore, the graphene transfer system according to the present invention can perform a first heat treatment process using the heat treatment module 430 in the first load lock chamber 110 where the substrate loading unit 400 is supplied in order to remove moisture residue on the transfer substrate 410 before the graphene transfer process is performed.

For example, depending on the direction of the current applied to the heat treatment module 430, the first heat transfer surface 432 in contact with the jig may be heated, and the second heat transfer surface 433 may be cooled. Therefore, by applying heat to the substrate loading unit 400 through the heating of the first heat transfer surface 432, the first heat treatment process can be performed.

The substrate loading unit 400, after the remaining moisture is completely removed from the first load lock chamber 110, is transferred to the substrate processing unit 200, thereby improving the quality of the graphene 510 transferred onto the transfer substrate 410. Furthermore, without the need for an additional process step to remove moisture residue on the substrate supply unit 100, the present invention can remove the moisture remaining in the substrate supply unit 100 through the heat treatment module 430 while the substrate supply unit 100 waits in the first load lock chamber 110, thereby enhancing mass production efficiency.

Continuously, in the second load lock chamber 120, a plurality of graphene transfer units 500 can be supplied and arranged from the outside. Additionally, the second load lock chamber 120 can be connected to the substrate processing unit 200. For example, the plurality of graphene transfer units 500 can be transferred to the substrate processing unit 200 in predetermined quantities.

The second load lock chamber 120 can be in a vacuum or atmospheric condition. For example, when the second load lock chamber 120 is in the atmospheric condition, graphene transfer units 500 can be supplied from the outside to the second load lock chamber 120. Also, when the second load lock chamber 120 is in the vacuum condition, graphene transfer units 500 can be transferred from the second load lock chamber 120 to the substrate processing unit 200.

In other words, the first load lock chamber 110 and the second load lock chamber 120 are each connected to the substrate processing unit 200, thereby enabling the transfer of the substrate loading unit 400 and the graphene transfer units 500 in the vacuum condition.

The graphene transfer unit 500 may include graphene 510, an adhesive material 520, and a carrier substrate 530.

The graphene 510 may be graphene formed on catalyst metal. For example, the graphene 510 may be a monolayer or multilayer graphene formed on the catalyst metal to a certain thickness, but is not limited thereto.

The graphene 510 formed on the catalyst metal may be attached to the carrier substrate 530 by the adhesive material 520. The carrier substrate 530 to which the graphene 510 is attached may be a substrate having acid resistance of pH 3 or less, alkali resistance of pH 10 or more, and heat resistance at 100°C to 300°C. That is, to ensure that the carrier substrate 530 is not damaged during the etching process of the catalyst metal and the graphene cleaning process, the carrier substrate 530 may have acid resistance or alkali resistance relative to acidic materials with pH 3 or less and basic materials with pH 10 or more, respectively.

The carrier substrate 530 may include, for example, polyethylene naphthalate (PEN), polyethylene terephthalate (PET), polyethersulfone (PES), polydimethylsiloxane (PDMS), polycarbonate (PC), polyimide (PI), polypropylene terephthalate (PPT), polyetherimide (PEI), or polyarylate (PAR), but is not limited thereto.

The adhesive material 520 may be an adhesive material having acid resistance of pH 3 or less, alkali resistance of pH 10 or more, and heat resistance at 100°C to 300°C. That is, the adhesive material 520 may have acid resistance or alkali resistance relative to acidic materials with pH 3 or less and basic materials with pH 10 or more, respectively, that may be encountered during the graphene transfer process using vacuum heat treatment of the present invention. Additionally, the adhesive material 520 may have heat resistance to maintain its properties even at temperatures of 100°C to 300°C during the graphene transfer process using vacuum heat treatment of the present invention. The adhesive material 520 may be formed to support the graphene 510 on the carrier substrate 530 to prevent damage to the graphene 510 during the process.

The adhesive material 520 may include, for example, polyimide (Polyimide), polymethylmethacrylate (PMMA), polydimethylsiloxane (PDMS), polyvinylidene fluoride (PVDF), or UV curable polymers, but is not limited thereto.

After the graphene 510 is attached to the carrier substrate 530 using the adhesive material 520, the catalyst metal arranged on one surface of the graphene 510 for the graphene transfer process can be removed. That is, the graphene transfer unit 500 having a graphene/adhesive material/carrier substrate structure that the catalyst metal is removed from a catalyst metal/graphene/adhesive material/carrier substrate structure can be supplied to the second load lock chamber 120.

Continuously, the substrate processing unit 200 receives the substrate from the substrate supply unit 100 and performs the graphene transfer process in the vacuum condition. That is, the substrate processing unit 200 can be a process vacuum chamber for transferring the graphene 510 onto the transfer substrate 410.

Additionally, the substrate processing unit 200 may include a first transfer chamber 210 and a second transfer chamber 220.

The first transfer chamber 210 can be connected to the first load lock chamber 110 and the second load lock chamber 120. For example, the first transfer chamber 210 can be connected to the first load lock chamber 110 and the second load lock chamber 120 to respectively communicate with the first load lock chamber 110 and the second load lock chamber 120. In this case, gates may be formed between the first transfer chamber 210 and the first load lock chamber 110, and between the first transfer chamber 210 and the second load lock chamber 120 to allow or block communication between the chambers.

For example, when transferring the substrate loading unit 400 or the graphene transfer unit 500 to the first transfer chamber 210, the first load lock chamber 110 and the second load lock chamber 120 can be changed from the atmospheric condition into the vacuum condition. When the first load lock chamber 110 or the second load lock chamber 120 is changed to the same vacuum condition as the first transfer chamber 210, the gates connecting the chambers are opened, thereby allowing the substrate loading unit 400 or the graphene transfer unit 500 to be transferred to the first transfer chamber 210. After the transfer of the substrate loading unit 400 or the graphene transfer unit 500 to the first transfer chamber 210 is completed, the gates are closed again, and the first transfer chamber 210 can be isolated from the first load lock chamber 110 or the second load lock chamber 120.

That is, the first transfer chamber 210 performing the graphene transfer process can maintain the vacuum condition even when substrates are loaded or unloaded for the process, and can selectively receive the substrate loading unit 400 or the graphene transfer unit 500 from the first load lock chamber 110 and the second load lock chamber 120 in the vacuum condition. Therefore, since there is no need to release vacuum and open the chambers every time to insert or discharge the substrate into or from the chamber, the present invention can reduce process time, and prevent deterioration in product quality due to external contamination. That is, the present invention can considerably enhance mass production efficiency for the graphene transfer process.

Moreover, to transfer the substrate loading unit 400 or the graphene transfer unit 500 from the substrate supply unit 100 to the first transfer chamber 210, a vacuum robot arm (not shown) or the like may be arranged between the substrate supply unit 100 and the first transfer chamber 210.

The first transfer chamber 210 may include a first support base 211 and a first roller 212.

The first support base 211 may be located at the bottom of the first transfer chamber 210. Therefore, the substrate loading unit 400 transferred to the first transfer chamber 210 can be placed on the first support base 211.

A first support base groove 201 may be formed on the top of the first support base 211. The first support base groove 201 may have the same size as the substrate loading unit 400. That is, the substrate loading unit 400 transferred to the first transfer chamber 210 can be attached to the first support base groove 201 and inserted and secured by the first support base groove 201 of the same size.

A first lift 213 and a second power supply unit 215 may be arranged within the first support base groove 201.

The first lift 213 can move in the upward or downward direction within the first support base groove 201. For example, the substrate loading unit 400 transferred from the first load lock chamber 110 to the first transfer chamber 210 can be placed on the first lift 213, and the substrate loading unit 400 placed on the first lift 213 can be placed within the first support base groove 201 by downward movement of the first lift 213.

The second power supply unit 215 may be positioned on the lower side of the first support base groove 201. The second power supply unit 215 can supply power to the heating module 430 of the substrate loading unit 400 placed on the first support base groove 201. In other words, the second power supply unit 215 can be inserted into the power groove 423 of the heating module 430 to be electrically connected to the heating module 430.

For example, depending on the direction of the current applied from the first transfer chamber 210 to the heat treatment module 430, the first heating surface 432 in contact with the jig 420 is cooled while the second heating surface 433 is heated. Therefore, the substrate loading unit 400 heated in the first heating process can be rapidly cooled by the cooling of the first heating surface 432. By rapidly cooling the substrate loading unit 400 with the heating module 430, the pressure process by the first roller 212 can be immediately performed. If the pressure process is performed when the temperature of the substrate loading unit 400 is high, damage and contamination of the graphene 510 placed under the graphene transfer unit 500 may occur, leading to defective graphene 510. However, the substrate loading unit 400 according to the present invention can prevent damage to the graphene 510 and shorten the process time by rapidly cooling the substrate loading unit 400 heated by the first heating process using the characteristics of the Peltier device.

A second lift 214 may be positioned on the upper portion of the first support base 211. The second lift 214 can support the graphene transfer unit 500 and move in the upward or downward direction. For example, when the substrate loading unit 400 is transferred from the first load lock chamber 110 to the first transfer chamber 210, the substrate loading unit 400 is mounted on the first lift 213 and secured to the first support base groove 201. In this case, the substrate loading unit 400 can be placed within the first support base groove 201 so that the transfer substrate 410 faces upward. After the substrate loading unit 400 is placed in the first support base groove 201, when the graphene transfer unit 500 is transferred from the second load lock chamber 120 to the first transfer chamber 210, the graphene transfer unit 500 is placed on the second lift 214. In this case, the graphene transfer unit 500 can be placed on the second lift 214 with the graphene 510 facing downward. Additionally, the graphene transfer unit 500 can be arranged to be adjacent to the substrate loading unit 400 by the second lift 214.

To move the second lift 214 in the upward or downward direction, an elastic member 215 may be positioned inside the second lift 214. That is, the second lift 214 can move in the upward or downward direction using the elasticity of the elastic member 215 placed inside the second lift 214. The elastic member 215 may, for example, be a spring with elasticity.

A first roller 212 for pressing the graphene transfer unit 500 may be positioned on the upper portion of the first transfer chamber 210. The first transfer chamber 210 can perform a roll-to-plate process using the first roller 212. For example, when the graphene transfer unit 500 is arranged close to the substrate loading unit 400, the first roller 212 can rotate while applying pressure to the graphene transfer unit 500. In other words, the first roller 212 can bond the graphene transfer unit 500 and the substrate loading unit 400 in a straight line by pressing the graphene transfer unit 500 while moving on the upper surface of the graphene transfer unit 500 from one side to the other side. Therefore, sequential contact between the graphene transfer unit 500 and the substrate loading unit 400 can be achieved by the first roller 212.

Accordingly, microbubbles that can be generated when the entire area of the graphene transfer unit 500 and the substrate loading unit 400 are simultaneously joined, or substances that may cause doping can be removed more effectively, thereby enhancing the adhesion between the graphene 510 and the transfer substrate 410 during graphene transfer, and securing the inherent characteristics of the graphene 510.

The second transfer chamber 220 can be connected to the first transfer chamber 210. For example, the second transfer chamber 220 can be connected to the first transfer chamber 210 in communication. In this case, a gate can be formed between the first transfer chamber 210 and the second transfer chamber 220. By the gate, the first transfer chamber 210 and the second transfer chamber 220 can be in communication or blocked from each other.

The second transfer chamber 220 can receive the substrate loading unit 400 and the graphene transfer unit 500, which have completed the roll-to-plate process, from the first transfer chamber 210. In other words, the substrate loading unit 400 and the graphene transfer unit 500 can be transferred in an adhered state by the roll-to-plate process. Therefore, the second transfer chamber 220 can also have a vacuum condition similar to the first transfer chamber 210.

Furthermore, to transfer the substrate loading unit 400 and the graphene transfer unit 500 from the first transfer chamber 210 to the second transfer chamber 220, a vacuum robot arm (not shown) or the like may be used between the first transfer chamber 210 and the second transfer chamber 220.

The second transfer chamber 220 may include a second support base 221 and a second roller 222.

The second support base 221 may be positioned at the bottom of the second transfer chamber 220. The second support base 221 may include a second support groove 202 where the graphene transfer unit 500 and the substrate loading unit 400 transferred from the first transfer chamber 210 can be placed and fixed. For example, the second support groove 202 may have the same size as the first support groove 201.

A third lift 223 and a third power supply unit 224 may be positioned inside the second support groove 202. The third lift 223 can move upward or downward inside the second support groove 202. For example, the substrate loading unit 400 and the graphene transfer unit 500 transferred from the first transfer chamber 210 to the second transfer chamber 220 can be placed on the third lift 223, and then placed inside the second support groove 202 by the downward movement of the third lift 223. In this case, the substrate loading unit 400 can be inserted and placed in the second support groove 202, while the graphene transfer unit 500 attached to the substrate loading unit 400 can be positioned to be exposed in the second support groove 202.

The third power supply unit 224 may be positioned on the bottom side of the second support groove 202. The third power supply unit 224 can supply power to the heat treatment module 430 of the substrate loading unit 400 placed on the second support groove 202. Thus, the third power supply unit 224 can be inserted into the power slot 423 of the heat treatment module 430 and electrically connected to the heat treatment module 430.

For example, depending on the direction of current applied from the second transfer chamber 220 to the heat treatment module 430, the first heating surface 432 in contact with the jig 420 is heated while the second heating surface 433 is cooled. Therefore, the substrate loading unit 400 can be heated by the heating of the first heating surface 432, thereby enabling the second heat treatment process.

The heat treatment module 430 can supply heat to the substrate loading unit 400 by contacting it while the graphene transfer unit 500 is in contact with the substrate loading unit 400, thereby allowing heat to be transmitted to the graphene transfer unit 500 through the substrate loading unit 400. The second heat treatment process in the second transfer chamber 220 can increase the adhesion between the transfer substrate 410 of the substrate loading unit 400 and the graphene 510 of the graphene transfer unit 500.

A second roller 222 for removing the carrier substrate 530 of the graphene transfer unit 500 may be positioned on the top of the second transfer chamber 220. The second transfer chamber 220 can perform a second roll-to-plate process using the second roller 222.

FIG. 8 illustrates the second roller of the present invention.

Referring to FIG. 8, a barb-shaped protrusion 203 can be formed on the outer peripheral surface of the second roller 222 of the graphene transfer unit 500 to remove the carrier substrate 530. For example, when heat is transferred to the substrate loading unit 400 and the graphene transfer unit 500 by the second heat treatment process, the adhesion between graphene 510 and the transfer substrate 410 can be increased. However, if the temperature of the transferred heat rises to the temperature required to remove the carrier substrate 530, the adhesive force of the adhesive material 520 bonding the graphene 510 and the carrier substrate 530 may weaken. In this case, the second roller 222 can rotate and move on the upper surface of the graphene transfer unit 500 from one side to the other side, and the protrusion 203 of the second roller 222 can be sequentially inserted into the surface of the carrier substrate 530, such that the carrier substrate 530 can be separated from the graphene 510. That is, by the rotational movement of the second roller 222, the carrier substrate 530 can be attached to or removed from the peripheral surface of the second roller 222.

As described above, the graphene transfer system according to the present invention allows the roll-to-plate process to be performed in the first transfer chamber 210, and the second transfer chamber 220 can perform the second heat treatment process and the second roll-to-plate process.

The conventional graphene transfer device has the problem of damage and contamination of graphene occurring because the graphene transfer process and the carrier substrate separation process are performed simultaneously with the application of pressure and heat by the roller within a single vacuum chamber. This is because when pressure and heat are applied to the carrier substrate simultaneously, the graphene attached to the flexible carrier substrate may tear due to deformation of the carrier substrate, or contamination of the graphene may occur due to gases or contaminants generated by thermal degradation at temperatures above 100°C.

However, the graphene transfer system according to the present invention, after performing the first roll-to-plate process for bonding the graphene 510 and the transfer substrate 410 inside the first transfer chamber 210, performs the second heat treatment and the second roll-to-plate process for carrier substrate 530 by moving to the second transfer chamber 220, thereby preventing graphene damage and contamination caused by phenomena resulting from simultaneous application of heat and pressure to the carrier substrate.

Furthermore, by sequentially performing the graphene transfer process using the vacuum chambers of the first transfer chamber 210 and the second transfer chamber 220, the present invention can shorten the processing time and improve mass production. In another embodiment, when there are multiple substrate processing units 200 connected to the substrate supply unit 100, the plurality of substrate loading units 400 and the plurality of graphene transfer units 500 placed in the substrate supply unit 100 can be transferred to the plurality of substrate processing units 200 respectively, to simultaneously perform the graphene process, thereby further improving mass production.

Continuously, the substrate discharge unit 300 can be connected to the substrate processing unit 200. More specifically, the substrate discharge unit 300 can be in a vacuum or atmospheric condition, and can be connected to the second transfer chamber 220 to communicate with the second transfer chamber 220. For example, when the graphene transfer process is completed in the second transfer chamber 220, the substrate loading unit 400 with the graphene 510 transferred can be transferred to the substrate discharge unit 300. In this case, the substrate discharge unit 300 can have the same vacuum condition as the second transfer chamber 220, and the substrate loading unit 400 can be transferred from the second transfer chamber 220 to the substrate discharge unit 300 under the same vacuum condition.

In addition, to transfer the substrate loading unit 400 from the second transfer chamber 220 to the substrate discharge unit 300, a vacuum robot arm or the like can be used between the second transfer chamber 220 and the substrate discharge unit 300. The transferred substrate loading unit 400 can be discharged externally by the atmospheric condition conversion of the substrate discharge unit 300.

FIG. 9 is a flowchart illustrating a graphene transfer method using the graphene transfer system of the present invention.

Referring to FIG. 9, the graphene transfer method using the graphene transfer system according to the present invention includes: a step (S610) of placing a transfer substrate 410 on a jig 420 and a graphene transfer unit 500 including a carrier substrate 530 to which graphene 510 is adhered, and preparing a substrate loading unit 400 having a heat treatment module 430 arranged on the bottom of the jig 420; a step (S620) of loading the substrate loading unit 400 and the graphene transfer unit 500 onto a substrate supply unit 100 in a vacuum or atmospheric condition, and performing a first heat treatment process using the heat treatment module 430; a step (S630) of transferring the substrate loading unit 400 and the graphene transfer unit 500 to a substrate processing unit 200 in the vacuum condition; a step (S640) of performing a second heat treatment process in the substrate processing unit 200 using the heat treatment module 430, and performing a graphene transfer process using the second heat treatment process; and a step (S650) of transferring the substrate loading unit 400 with the transferred graphene 510 to a substrate discharge unit 300.

FIGS. 10 to 16 sequentially illustrate the graphene transfer method using the graphene transfer system of the present invention.

Referring to FIGS. 10 to 16, the graphene transfer method using the graphene transfer system of the present invention will be described sequentially.

First, referring to FIG. 10, the graphene transfer unit 500 and the substrate loading unit 400 are prepared (S610) . The graphene transfer unit 500 adheres the graphene 510 formed on catalyst metal onto a carrier substrate 530 using an adhesive material 520, and then, removes the catalyst metal, so the graphene transfer unit 500 having a graphene/adhesive material/carrier substrate can be prepared.

The substrate loading unit 400 can be prepared by inserting and placing the transfer substrate 410 into a seating groove 421 formed on the upper surface of the jig 420 and adhering the heat treatment module 430 for heat treatment process to the lower portion of the jig 420. Here, the heat treatment module 430 may be a Peltier device. In this case, it is desirable for the upper surface of the transfer substrate 410 inserted into the seating groove 421 of the jig 420 to be arranged to be in the same plane as the upper surface of the jig 420. Additionally, it is desirable for the upper surface of the jig 420 to have a peripheral area 422 excluding the area where the transfer substrate 410 is placed.

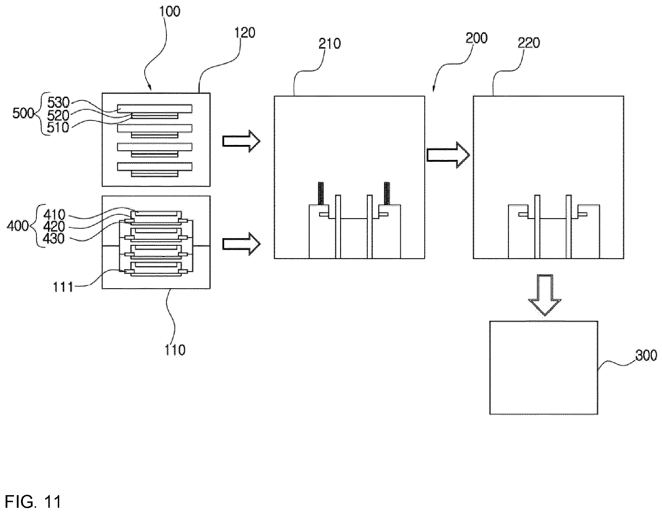

Referring to FIG. 11, the prepared substrate loading unit 400 and graphene transfer unit 500 are supplied to the substrate supply unit 100 (S620). For example, the substrate loading unit 400 can be supplied to the first load lock chamber 110, and the graphene transfer unit 500 can be supplied to the second load lock chamber 120. When the substrate loading unit 400 and the graphene transfer unit 500 are supplied to the first load lock chamber 110 and the second load lock chamber 120, the first load lock chamber 110 and the second load lock chamber 120 can be maintained in the atmospheric condition. The substrate supply unit 100 may supply multiple substrate loading units 400 or multiple graphene transfer units 500.

The plurality of substrate loading units 400 supplied to the first load lock chamber 110 may undergo a first heat treatment process to remove moisture remaining on the transfer substrate 410. The first heat treatment process can be performed by placing the heat treatment module 430 connected electrically to a first power supply unit 111 formed in the first load lock chamber 110 below the substrate loading unit 400 and heating the substrate loading unit 400 by the heat treatment module 430 connected to the first power supply unit 111.

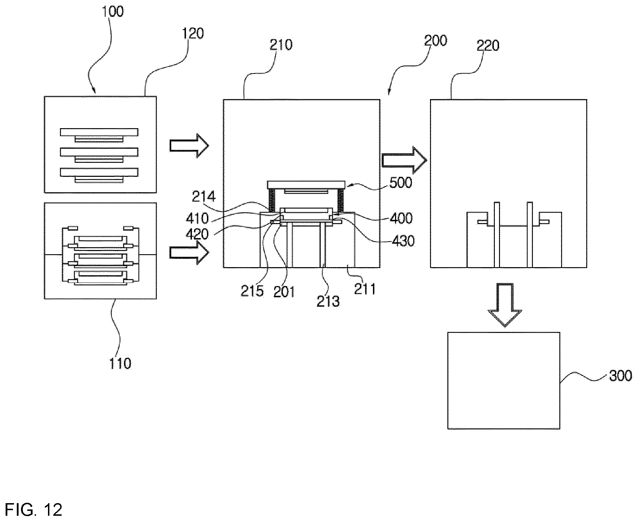

Referring to FIG. 12, the substrate loading unit 400 and the graphene transfer unit 500 are transferred to the substrate processing unit 200 for the graphene transfer process (S630). In more detail, the first load lock chamber 110 is converted into the vacuum condition, and the substrate loading unit 400 provided in the first load lock chamber 110 can be transferred to a first transfer chamber 210 in the vacuum condition. The substrate loading unit 400 transferred to the first transfer chamber 210 can be placed within a first support groove 201 by a first lift 213. Subsequently, the graphene transfer unit 500 can be transferred to the first transfer chamber 210 in the vacuum condition of the second load lock chamber 120. The graphene transfer unit 500 transferred to the first transfer chamber 210 can be arranged to be close to the substrate loading unit 400 by a second lift 214.

In this instance, the substrate loading unit 400 placed in the first support groove 201 can be cooled using the heat treatment module 430. That is, the second power supply unit 215 arranged in the first support groove 201 can be electrically connected to the heat treatment module 430 placed below the substrate loading unit 400, and the heat treatment module 430 connected to the second power supply unit 215 can cool the substrate loading unit 400 heated by the first heat treatment process.

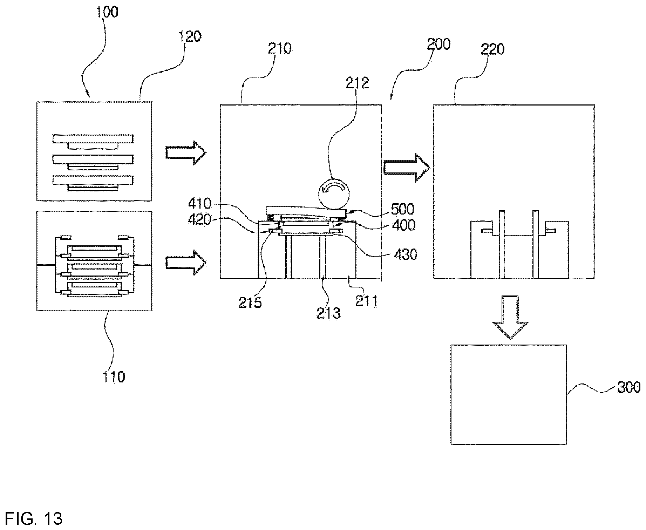

Referring to FIG. 13, after cooling of the substrate loading unit 400, a first roller 212 is used to perform a first roll-to-plate process. The first roller 212 can apply pressure to the upper surface of the graphene transfer unit 500 stacked on the substrate loading unit 400. In this case, the first roller 212 can press the graphene transfer unit 500 while moving on the upper surface of the graphene transfer unit 500 from one side to the other side, thereby bonding the graphene transfer unit 500 and the substrate loading unit 400 in a straight line.

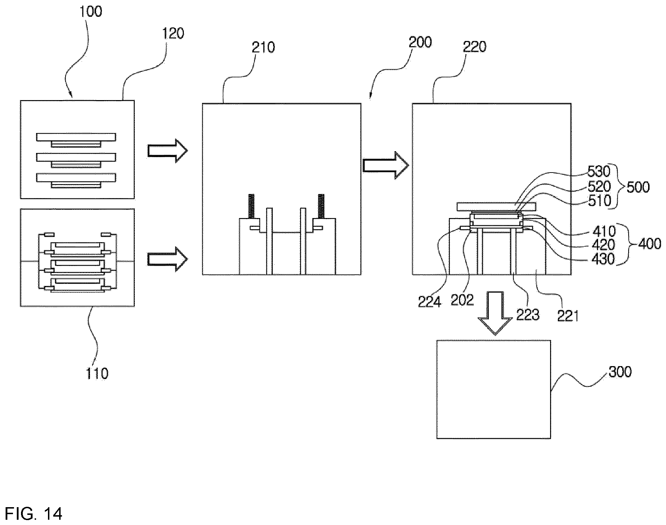

Referring to FIG. 14, the substrate loading unit 400 and the graphene transfer unit 500 that have been bonded in the first transfer chamber 210 are transferred to a second transfer chamber 220 (S640). The substrate loading unit 400 and the graphene transfer unit 500 transferred to the second transfer chamber 220 can be inserted into and placed into a second support groove 202 by a third lift 223. When the substrate loading unit 400 and the graphene transfer unit 500 are placed in the second support groove 202, a second heat treatment process can be performed to enhance the adhesion between the graphene 510 and the transfer substrate 410. The second heat treatment process can be performed by placing the heat treatment module 430 electrically connected to a third power supply unit 224 formed in the second support groove 202 below the substrate loading unit 400 and heating the substrate loading unit 400 by the heat treatment module 430 connected to the third power supply unit 224.

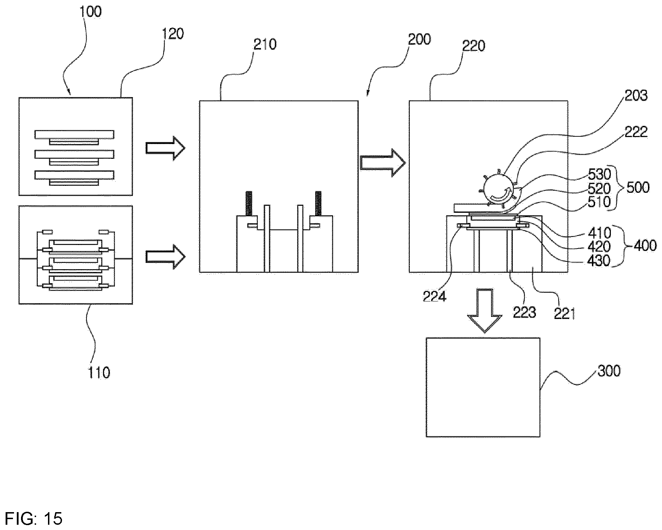

Referring to FIG. 15, a second roll-to-plate process is performed using the second roller 222. The second roll-to-plate process can be performed during the second heat treatment process. For example, the second heat treatment process enhances the adhesion force between the graphene 510 and the transfer substrate 410, but weakens the adhesion force of the adhesive 520 placed between the graphene 510 and the carrier substrate 530 by the heat treatment temperature. When the adhesion force of the adhesive 520 is weakened, the second roller 222 can remove the carrier substrate 530 while being in contact with the upper surface of the graphene 510. That is, when the second roller 222 gets in contact with the upper surface of the graphene 510, the protrusion 203 of a middle shape formed on the second roller 222 penetrates the surface of the carrier substrate 530, and then, is caught to the carrier substrate 530, and the second roller 222 moves on the upper surface of the graphene 510 from one side to the other side to sequentially remove the carrier substrate 530 caught on the protrusion 203.

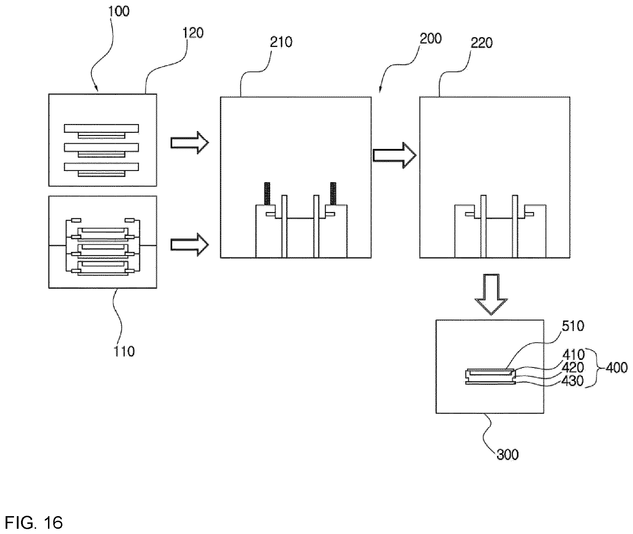

Referring to FIG. 16, the substrate loading unit 400 with graphene 510 transferred is transferred to the substrate discharge unit 300 (S650). The substrate discharge unit 300 can be switched into the vacuum condition to receive the substrate loading unit 400 with transferred graphene 510. That is, when the second transfer chamber 220 and the substrate discharge unit 300 are in the same vacuum condition, the substrate loading unit 400 with transferred graphene 510 can be transferred from the second transfer chamber 220 to the substrate discharge unit 300. The substrate discharge unit 300 completed transferred to the substrate discharge unit 300 can be discharged to the outside after the substrate discharge unit 300 is switched into the atmospheric condition.

According to the present invention, by including the substrate supply unit 100 capable of supplying the substrate loading unit 400 and the graphene transfer unit 500 in the vacuum or atmospheric condition, the process time can be shortened, and deterioration of product quality due to external contamination can be prevented. Therefore, the present invention can significantly improve the productivity for the graphene transfer process. Furthermore, by using the heat treatment module 430, the present invention can remove moisture remaining in the substrate loading unit 400 before the graphene transfer process is performed and rapidly cool the substrate loading unit 400 heated by the heat treatment process, thereby shortening the process time. Therefore, the present invention can enhance the quality of graphene transfer and improve productivity due to the reduction in process time.

In addition, by separating the first roll-to-plate process for bonding graphene 510 to the transfer substrate 410 from the second roll-to-plate process for heat treatment and separation of the carrier substrate 530, the present invention can prevent damage and contamination of graphene 510 due to pressure and heat applied to the carrier substrate 530.

Meanwhile, the embodiments of the present invention disclosed in this specification and drawings are merely provided for illustrative purposes to aid understanding and do not intend to limit the scope of the present invention. It is evident to those skilled in the art that other modification examples based on the technical concept of the present invention can be implemented within the ordinary knowledge in the field to which the present invention belongs.

## Claims

1. A graphene transfer system using a heat treatment module, comprising:
a substrate supply unit supplying a substrate loading unit and a graphene transfer unit in a vacuum condition and performing a first heat treatment process;
a substrate processing unit receiving the graphene transfer unit and the substrate loading unit and performing a graphene transfer process through a second heat treatment process; and
a substrate discharge unit for discharging the substrate loading unit, after completion of the graphene transfer process in the substrate processing unit,
wherein the graphene transfer unit includes a carrier substrate to which graphene is adhered, and
wherein the substrate loading unit includes a heat treatment module for performing the first heat treatment process and the second heat treatment process.

2. The graphene transfer system according to claim 1, wherein the substrate loading unit comprises:
a transfer substrate on which the graphene is transferred; and
a jig on which the transfer substrate is place.

3. The graphene transfer system according to claim 2, wherein the heat treatment module is arranged under the jig.

4. The graphene transfer system according to claim 2, wherein the jig comprises a seating groove for inserting and placing the transfer substrate into the jig.

5. The graphene transfer system according to claim 2, wherein the upper surface of the jig is in the same plane as the upper surface of the transfer substrate.

6. The graphene transfer system according to claim 1, wherein the heat treatment module comprises a Peltier device.

7. The graphene transfer system according to claim 1, wherein the substrate supply unit comprises:
a first load lock chamber supplying the substrate loading unit to the substrate processing unit in the vacuum condition; and
a second load lock chamber supplying the graphene transfer unit to the substrate processing unit in the vacuum condition.

8. The graphene transfer system according to claim 7, wherein the first load lock chamber comprises a first power supply unit for supplying power to the heat treatment module.

9. The graphene transfer system according to claim 1, wherein the substrate processing unit comprises:
a first transfer chamber receiving the substrate loading unit and the graphene transfer unit from the substrate supply unit, and performing a first roll-to-plate process in the vacuum condition; and
a second transfer chamber receiving the substrate loading unit and the graphene transfer unit from the first transfer chamber, and performing a second heat treatment process and a second roll-to-plate process.

10. The graphene transfer system according to claim 9, wherein the first transfer chamber comprises:
a first support base, which is placed under the first transfer chamber, and on which the substrate loading unit is placed; and
a first roller which is placed on the upper part of the first transfer chamber, and applies pressure to the graphene transfer unit to bond the graphene to the substrate loading unit.

11. The graphene transfer system according to claim 10, wherein the first support base includes a second power supply unit for supplying power to the heat treatment module, and
wherein the heat treatment module cools the substrate loading unit by the second power supply unit.

12. The graphene transfer system according to claim 9, wherein the second transfer chamber comprises:
a second support base which is placed under the second transfer chamber, and on which the substrate loading unit is placed; and
a second roller which is placed on the upper part of the second transfer chamber to remove the carrier substrate from the graphene transfer unit.

13. The graphene transfer system according to claim 12, wherein the second support base includes a third power supply unit for supplying power to the heat treatment module, and
wherein the heat treatment module supplies heat to the substrate loading unit by the third power supply unit.

14. The graphene transfer system according to claim 12, wherein the second roller includes a barb-shaped protrusion formed on the outer surface thereof.

15. A graphene transfer method of a graphene transfer system using a heat treatment module, comprising the steps of:
placing a transfer substrate on a jig and a graphene transfer unit including a carrier substrate to which graphene is adhered, and preparing a substrate loading unit having a heat treatment module arranged on the bottom of the jig;
loading the substrate loading unit and the graphene transfer unit onto a substrate supply unit in a vacuum or atmospheric condition, and performing a first heat treatment process using the heat treatment module;
transferring the substrate loading unit and the graphene transfer unit to a substrate processing unit in the vacuum condition;
performing a second heat treatment process in the substrate processing unit using the heat treatment module, and performing a graphene transfer process using the second heat treatment process; and
transferring the substrate loading unit with the transferred graphene to a substrate discharge unit.

16. The graphene transfer method according to claim 15, wherein the step of loading the substrate loading unit and the graphene transfer unit onto the substrate supply unit comprises the steps of:
loading the substrate loading unit into a first load lock chamber; and
loading the graphene transfer unit into a second load lock chamber.

17. The graphene transfer method according to claim 16, further comprising the step of:
after loading the substrate loading unit into the first load lock chamber, supplying power to the heat treatment module in the first load lock chamber to perform the first heat treatment process.

18. The graphene transfer method according to claim 15, wherein the step of performing the graphene transfer process comprises the steps of:
transferring the substrate loading unit and the graphene transfer unit to a first transfer chamber; and
transferring the substrate loading unit and the graphene transfer unit from the first transfer chamber to a second transfer chamber.

19. The graphene transfer method according to claim 18, wherein the step of performing the graphene transfer process comprises the steps of:
performing a first roll-to-plate process in the first transfer chamber; and
performing a second heat treatment process and a second roll-to-plate process in the second transfer chamber.

20. The graphene transfer method according to claim 19, wherein the step of performing the first roll-to-plate process comprises the steps of:
applying power to the heat treatment module to cool the substrate loading unit; and
positioning the graphene transfer unit close to the substrate loading unit and applying pressure to the upper portion of the positioned graphene transfer unit using a first roller.

21. The graphene transfer method according to claim 19, wherein the step of performing the second heat treatment process and the second roll-to-plate process comprises the steps of:
applying power to the heat treatment module to supply heat to the substrate loading unit and the graphene transfer unit; and
removing the carrier substrate of the graphene transfer unit using a second roller in the state in which the heat is supplied.
